# EUROPEAN PATENT APPLICATION

(11) **EP 2 733 754 A2**
(43) Date of publication of application: **21.05.2014**
(21) Application number: 13154793.7
(22) Date of filing: 11.02.2013
(51) Int. Cl.: H01L 33/62, H01L 25/075

(54) **Light-emitting module**

(30) Priority: 16.11.2012 JP 2012252715
(71) Applicant: Toshiba Lighting & Technology Corporation, Yokosuka-shi Kanagawa 237-8510 (JP)
(72) Inventor: Sasaki, Akihiro, Kanagawa, 237-8510 (JP); Betsuda, Nobuhiko, Kanagawa, 237-8510 (JP)
(74) Representative: Bokinge, Ole

(57) **Abstract**

A light-emitting module that can prevent a short circuit of an LED chip due to its mounting is to be provided. According to one embodiment, a light-emitting module (10) includes an LED chip (12), a direct plated copper (DPC) substrate (11), and solder joining sections (25N, 25P). The LED chip is of face-down type. The DPC substrate includes a mounting surface (13a) on which the LED chip is mounted. First and second wiring patterns (15N, 15P) including first and second land sections (16N, 16P) are formed on the mounting surface. The LED chip and the first and second land sections of the DPC substrate are joined by the first and second solder joining sections. At least the second land section (16P) is formed further on the inner side than the side surfaces of the LED chip.

## Description

### FIELD

Embodiments described herein relate generally to a light-emitting module in which an LED element of a face-down type is used.

### BACKGROUND

In a light-emitting module used for a luminaire or the like in the past, a wiring pattern is formed on a mounting surface of a substrate and an LED element is mounted on the wiring pattern.

As the LED element, there are a face-up type and a face-down type. In the face-up type, a light-emitting layer is formed on the upper surface side of a light irradiating direction. In the face-down type, a light-emitting layer is formed on the lower surface side on the opposite side of the light irradiating direction. In the case of the LED element of the face-down type, the light-emitting layer functioning as a heat generation source is close to the substrate side. Therefore, it is possible to allow heat generated by the LED element to easily escape to the substrate side. As a result, it is possible to cope with an increase in an output of the light-emitting module.

The LED element of the face-down type includes a P layer and an N layer as light-emitting layers. Solder joining sections of two poles respectively connected to a P layer and an N layer are formed on the lower surface of the LED element.

As a mounting method for mounting the LED element of the face-down type on the substrate, for example, there is a flip-chip mounting method. In the flip-chip mounting method, the solder joining sections of the LED element are pressed against land sections and heated. The temperature of a solder material of the solder joining sections rises to temperature equal to or higher than a melting point, whereby the solder material is melted to form alloy layers between the solder joining sections and the land sections and joined to the land sections.

However, when the solder joining sections of the LED element are joined to the land sections of the substrate, the solder material melted to have liquidity sometimes oozes out to the sides of the LED element from between the LED element and the land sections and creeps up the side surfaces of the LED element with surface tension.

In the LED element of the face-down type, the P layer and the N layer are located on the lower surface of the LED element. However, the P layer or the N layer or both of the P layer and the N layer are sometimes exposed to the side surfaces. Therefore, it is likely that the P layer and the N layer are likely to be short-circuited with the land sections and the solder joining sections having the opposite polarity by the melted solder material that creeps up the side surfaces of the LED element.

### BRIEF DESCRIPTION OF THE DRAWINGS

FIG. 1 is a sectional view of a light-emitting module according to an embodiment;
FIG. 2 is a plan view of a substrate showing a first wiring structure for land sections of the light-emitting module and a first wiring structure to the land sections;
FIG. 3 is a sectional view of a light-emitting module having the structure in the past compared with the light-emitting module;
FIG. 4 is a plan view of the light-emitting module;
FIG. 5 is a plan view of the substrate showing a second wiring structure to the land sections;
FIG. 6 is a perspective view of the substrate showing the second wiring structure;
FIG. 7 is a plan view of the substrate showing a third wiring structure to the land sections; and
FIG. 8 is a sectional view of the light-emitting module showing a fourth wiring structure to the land sections.

### DETAILED DESCRIPTION

It is an object of the present invention to provide a light-emitting module that can prevent a short circuit of an LED element due to mounting.

In general, according to one embodiment, a light-emitting module includes an LED element, a substrate, and a solder joining section. The LED element is a face-down type. The substrate includes a mounting surface on which the LED element is mounted. A wiring pattern including a land section is formed on the mounting surface. The LED element and the land section of the substrate are joined by the solder joining section. The land section is formed further on the inner side than the side surfaces of the LED element.

Consequently, it can be expected that a short circuit of the LED element is prevented.

An embodiment is explained below with reference to the accompanying drawings.

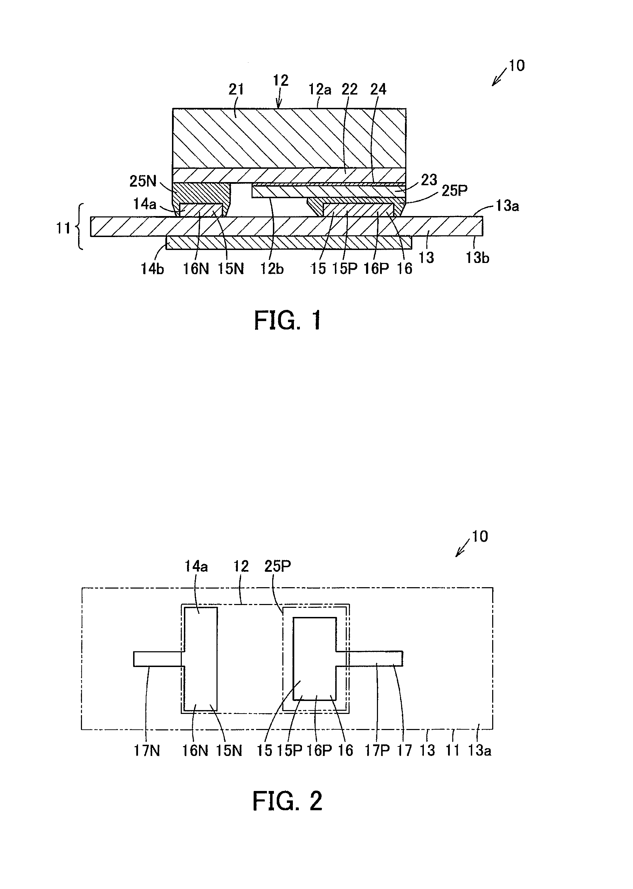

A sectional view of a light-emitting module 10 is shown in FIG. 1. The light-emitting module 10 includes a DPC (Direct Plated Copper) substrate 11 functioning as a substrate and an LED element 12 mounted on the DPC substrate 11.

The DPC substrate 11 includes a ceramic substrate 13. The surface of the ceramic substrate 13 is a mounting surface 13a functioning as a first surface. The opposite side of the mounting surface 13a is a rear surface 13b functioning as a second surface.

A wiring electrode 14a is formed on the mounting surface 13a. A wiring electrode 14b is formed on the rear surface 13b. The wiring electrodes 14a and 14b include electrode layers formed on the surface of the ceramic substrate 13. The wiring electrode 14a is a wiring pattern 15 formed in a predetermined shape. The wiring electrode 14b is formed over substantially the entire area of the rear surface 13b.

The electrode layer is a layer obtained by forming, with copper plating, a copper plating layer having thickness of about 25 to 75 µm on a seed layer formed by sputtering of metal such as titanium. The electrode layer may be a layer obtained by further forming a metal plating layer on the copper plating layer by plating nickel and gold or nickel, palladium, and gold with an electrolytic plating method, an electroless plating method, or the like. In the case of the electroless plating method, the metal plating layer can be formed not only on the principal plane but also the side surfaces of the wiring pattern 15.

As shown in FIGS. 1 and 2, the wiring pattern 15 includes a first wiring pattern 15N and a second wiring pattern 15P on which the LED element 12 is mounted. On the first wiring pattern 15N, a first land section 16N functioning as a land section 16 and a first wiring section 17N functioning as a wiring section 17 of a first wiring structure connected to the first land section 16N are formed. On the second wiring pattern 15P, a second land section 16P functioning as the land section 16 and a second wiring section 17P functioning as the wiring section 17 of the first wiring structure connected to the second land section 16P are formed. The land sections 16N and 16P are formed in, for example, a square shape. The wiring sections 17N and 17P are respectively connected to edge portion centers on the opposite side of opposed edge portions of the land sections 16N and 16P. The wiring sections 17N and 17P are formed at a width dimension smaller than the width of the land sections 16N and 16P. In FIG. 1, a sectional view of the light-emitting module 10 cut in the portions of the land sections 16N and 16P is shown.

The LED element 12 is a bare chip of the face-down type. The LED element 12 includes an upper surface 12a functioning as a first principal plane, which is a surface on a side for emitting light, and a lower surface 12b functioning as a second principal plane, which is a surface located on the opposite side of the upper surface 12a, i.e., on the substrate 11 side. The LED element 12 includes a sapphire layer 21 functioning as a transparent layer on the upper surface 12a side. An N layer 22 functioning as a first semiconductor layer and a P layer 23 functioning as a second semiconductor layer are formed on a rear surface 21b side of the sapphire layer 21. A light-emitting layer 24 is formed between the N layer 22 and the P layer 23. Further, on the lower surface 12b side of the LED element 12, a first solder joining section 25N functioning as a solder joining section connected to an electrode section of the N layer 22 and a second solder joining section 25P functioning as a solder joining section connected to an electrode section of the P layer 23 are formed a predetermined space apart from each other. The solder joining sections 25N and 25P of two poles are a solder material made of, for example, an alloy of gold and tin and are formed in a square shape. The LED element 12 is formed in a rectangular parallelepiped shape elongated in a direction in which the solder joining sections 25N and 25P of the two poles are arranged. In this embodiment, the N layer 22 is exposed to the peripheral surface of the LED element 12. The first solder joining section 25N and the P layer 23 are insulated from each other.

The LED element 12 is mounted on the DPC substrate 11 by, for example, a flip-chip mounting method. Specifically, the solder joining sections 25N and 25P of the LED element 12 are pressed against the land sections 16N and 16P and heated. The temperature of the solder material of the solder joining sections 25N and 25P rises to temperature equal to or higher than a melting point, whereby the solder joining sections 25N and 25P are melted to form alloy layers between the solder joining sections 25N and 25P and the land sections 16N and 16P and joined to the land sections 16N and 16P.

At this point, a relation between the second solder joining section 25P of the LED element 12 and the second land section 16P is as explained below. The second land section 16P is arranged further on the inner side than the side surfaces of the LED element 12. That is, an edge portion of the second land section 16P on the opposite side of an edge portion thereof opposed to the first land section 16N and a pair of edge portions of the second land section 16P opposed to the long sides of the LED element 12 are arranged further on the inner side than the short side surface and the long side surfaces of the LED element 12. More desirably, the second land section 16P is arranged further on the inner side than the side surfaces of the second solder joining section 25P. Therefore, the area of the second land section 16P is smaller than the area of the second solder joining section 25P.

According to such a relation between the second solder joining section 25P and the second land section 16P, the melted solder material of the second solder joining section 25P, which is melted to have fluidity when the LED element 12 is mounted, flows down from the peripheral portion of the second land section 16P to the ceramic substrate 13 side. The melted solder material can be prevented from oozing out from the side surfaces of the LED element 12 and creeping up the side surfaces of the LED element 12. Therefore, it is possible to prevent a short circuit of the LED element 12. A relation between the first solder joining section 25N of the LED element 12 and the first land section 16N is set the same as the relation between the second solder joining section 25P and the second land section 16P.

The areas of the second land section 16P and the first land section 16N may be set to different sizes or may be set to the same size. When the areas of the second land section 16P and the first land section 16N are set to different sizes, it is possible to distinguish the second land section 16P and the first land section 16N. Therefore, there is an advantage in terms of a manufacturing method. The likelihood of a short circuit due to the creeping-up of the melted solder material is high on the second land section 16P side. Therefore, only the second land section 16P side may be arranged further on the inner side than the side surfaces of the LED element 12.

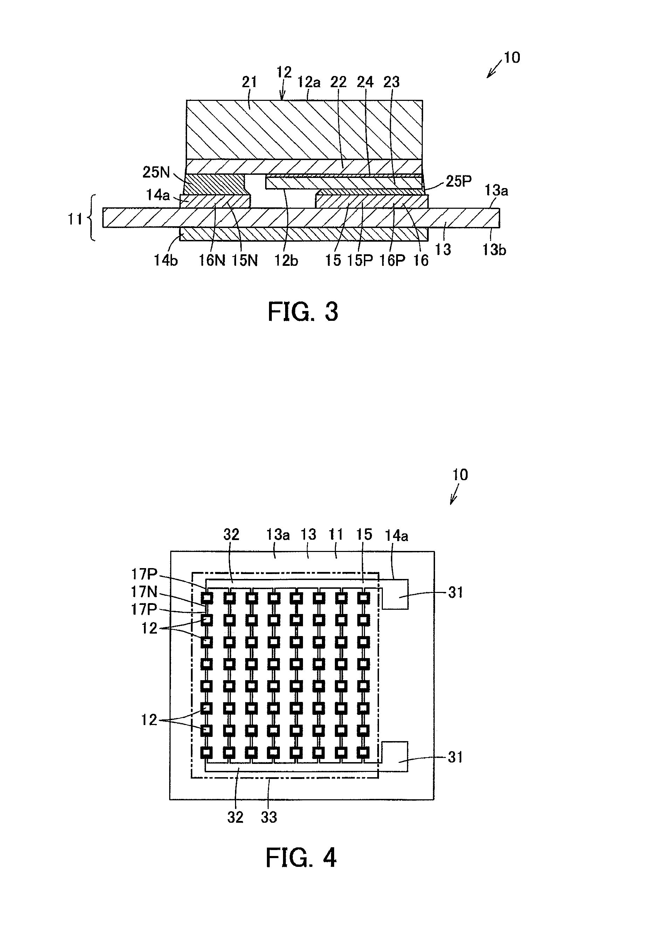

A sectional view showing a light-emitting module having the structure in the past compared with the light-emitting module 10 according to this embodiment is shown in FIG. 3. Components same as the components of the light-emitting module 10 according to this embodiment are explained using the same reference numerals and signs.

A relation between the second solder joining section 25P of the LED element 12 and the second land section 16P is as explained below. The second land section 16P is arranged further on the outer side than the side surfaces of the LED element 12 and the side surfaces of the second solder joining section 25P. That is, an edge portion of the second land section 16P on the opposite side of an edge portion thereof opposed to the first land section 16N are arranged further on the outer side than the short side surface and the long side surfaces of the LED element 12. Although not shown in the figure, a pair of edge portions of the second land section 16P opposed to the long sides of the LED element 12 are also arranged further on the outer side than the long side surfaces of the LED element 12. Therefore, the area of the second land section 16P is larger than the area of the second solder joining section 25P.

Because of such a relation between the second solder joining section 25P and the second land section 16P, the melted solder material of the second solder joining section 25P, which is melted to have fluidity when the LED element 12 is mounted, sometimes oozes to the sides of the LED element 12 from between the LED element 12 and the second land section 16P, creeps up the side surfaces of the LED element 12 with surface tension, reaches the N layer 22, and short-circuits with the N layer 22.

Therefore, by adopting the relation between the second solder joining section 25P and the second land section 16P of the light-emitting module 10 according to this embodiment, it is possible to prevent the N layer 22 and the P layer 23 of the LED element 12 from short-circuiting via the solder.

The second wiring section 17P for power supply is connected to the second land section 16P. Therefore, the melted solder material of the second solder joining section 25P, which is melted to have fluidity when the LED element 12 is mounted, flows down from the peripheral portion of the second land section 16P to the ceramic substrate 13 side in a place other than the second wiring section 17P. However, in the place of the second wiring section 17P, the melted solder material could ooze out onto the second wiring section 17P.

However, the second wiring section 17P is formed at a width dimension smaller than the width of the second land section 16P. Therefore, since a part of the melted solder material oozing out onto the second wiring section 17P flows down from both the sides of the second wiring section 17P to the ceramic substrate 13 side, it is possible to suppress the melted solder material from creeping up the side surfaces of the LED element 12. Therefore, it is possible to prevent the N layer 22 and the P layer 23 from short-circuiting via the solder.

Moreover, since the wiring sections 17N and 17P are formed at the width dimension smaller than the width of the land sections 16N and 16P, it is possible to improve light-emitting efficiency of the light-emitting module 10. This is because, when the reflectance of the surface (e.g., a metal plating layer of nickel and gold or nickel, palladium, and gold) of the wiring electrode 14a and the reflectance of the surface of the ceramic substrate 13 are compared, the reflectance of the surface of the wiring electrode 14a is lower. By reducing the width of the wiring sections 17N and 17P and reducing a rate of the area of the wiring electrode 14a to the ceramic substrate 13, it is possible to increase the reflection efficiency of the surface of the DPC substrate 11 and improve the light-emitting efficiency of the light-emitting module 10. When the creeping-up of the melted solder material and the reflection efficiency are taken into account, the width of the wiring sections 17N and 17P is desirably equal to or smaller than a half and more desirably equal to or smaller than a third of the width of the land sections 16N and 16P. However, when the supply of an electric current to the LED element 12 is taken into account, the width of the wiring sections 17N and 17P is more desirably equal to or larger than a tenth of the width of the land sections 16N and 16P.

Further, since the area of the land sections 16N and 16P is formed smaller than the area of the solder joining sections 25N and 25P, a rate of the area of the land sections 16N and 16P to the ceramic substrate 13 decreases. Therefore, it is possible to increase the reflection efficiency of the surface of the DPC substrate 11 and improve the light-emitting efficiency of the light-emitting module 10.

A plan view of the light-emitting module 10 is shown in FIG. 4. The wiring pattern 15 is formed on the mounting surface 13a of the DPC substrate 11. A plurality of LED elements 12 are mounted on the wiring pattern 15.

The wiring pattern 15 includes a pair of terminal sections 31 to which direct-current power for lighting the LED element 12 is supplied from the outside and a pair of power-supply wiring sections 32 connected to the pair of terminal sections 31. A plurality of wiring sections 17N and 17P and a plurality of land sections 16N and 16P are formed in parallel between the pair of power-supply wiring sections 32. The plurality of LED elements 12 are mounted on the plurality of land sections 16N and 16P.

As explained above, it is possible to reduce the rates of the areas of the wiring sections 17N and 17P and the land sections 16N and 16P to the ceramic substrate 13. Therefore, it is possible to increase the reflection efficiency of the surface of the DPC substrate 11 and improve the light-emitting efficiency of the light-emitting module 10.

Reference numeral 33 in FIG. 4 denotes sealing resin for sealing the plurality of LED elements 12. The sealing resin 33 contains a phosphor excited by light generated by the plurality of LED elements 12. For example, when the light-emitting module 10 radiates white light, the LED element 12 that emits blue light and a phosphor containing a yellow color as a main component are used. The blue light generated by the LED element 12 and yellow light generated by the phosphor excited by the blue light generated by the LED element 12 are mixed. White light is radiated from the surface of the sealing resin 33. According to a color of light to be irradiated, the LED element 12 and a phosphor of colors corresponding to the color are used.

The wiring electrode 14b of the light-emitting module 10 is connected to a heat spreader. Heat generated by the LED element 12 of the light-emitting module 10 during light emission is conducted to the heat spreader to radiate heat.

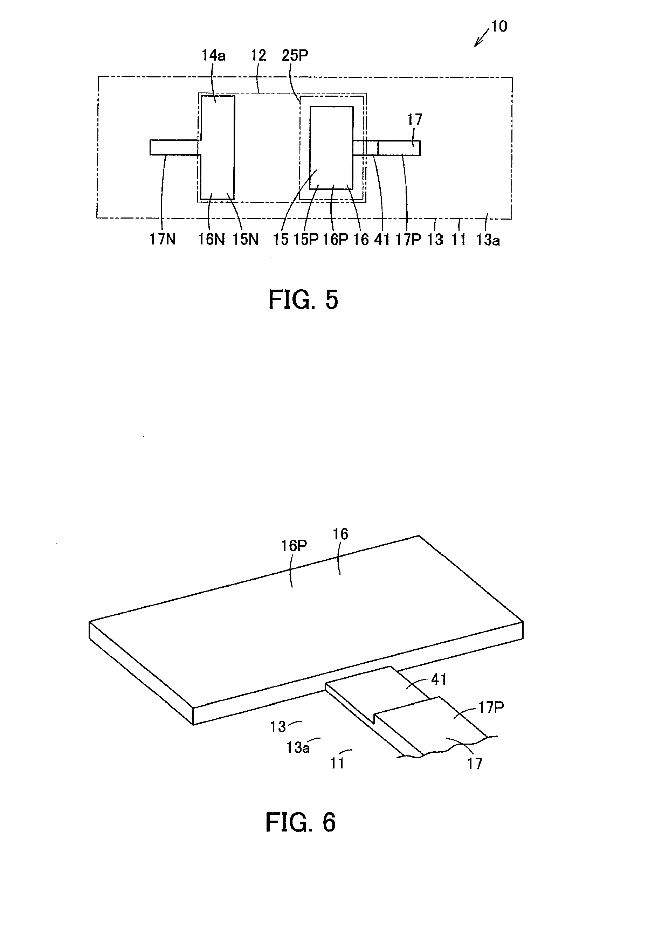

The second wiring section 17P of a second wiring structure to the land sections 16N and 16P is shown in FIGS. 5 and 6. In the second wiring section 17P, a step section 41 lower than the surface of the second land section 16P is formed in a boundary portion between the second wiring section 17P and the second land section 16P. The step section 41 can be easily manufactured by patterning in forming a copper plating layer of the wiring electrode 14a with plating. The dimension of a step of the step section 41 is desirably larger than the thickness (1 to 7 µm) of the second joining section 25P between the P layer 23 of the LED element 12 and the second land section 16P. Further, a wall of the step section 41 on the side of the boundary portion between the second wiring section 17P and the second land section 16P is arranged further on the inner side than the side surface of the LED element 12 and the side surface of the second solder joining section 25P. A wall of the step section 41 on the opposite side is arranged further on the outer side than the side surfaces.

The melted solder material of the second solder joining section 25P, which is melted to have fluidity when the LED element 12 is mounted, oozes out onto the second wiring section 17P in the place of the second wiring section 17P. However, since the melted solder material flows down to the step section 41, it is possible to suppress the melted solder material from creeping up the side surfaces of the LED element 12 and prevent the N layer 22 and the P layer 23 from short-circuiting.

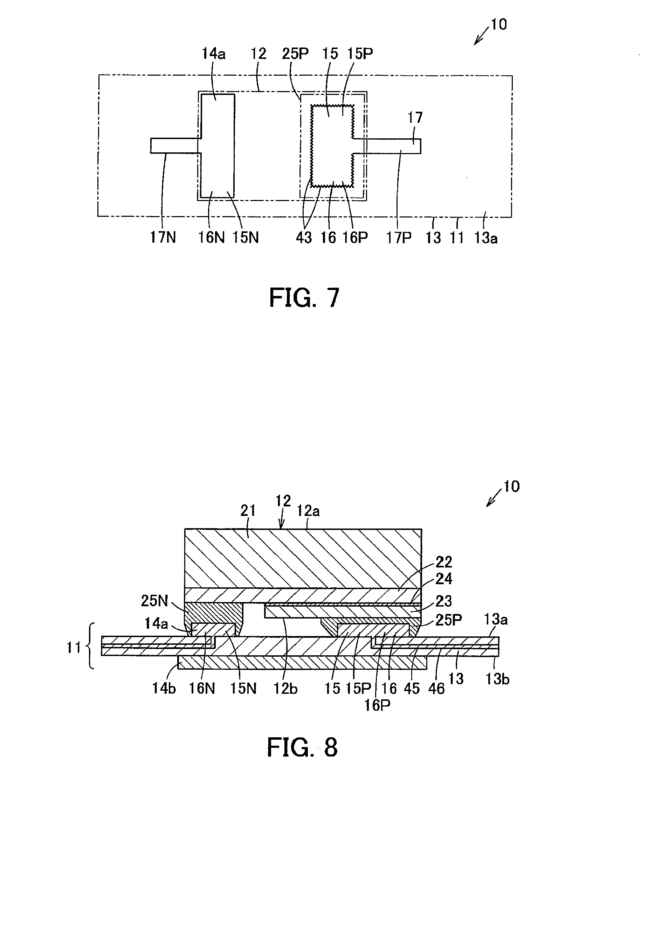

The second wiring section 17P of a third wiring structure to the land sections 16N and 16P is shown in FIG. 7. In the peripheral portion of the second land section 16P (other than the place of the second wiring section 17P), a plurality of grooves 43 V-shaped in cross section are formed along the up down direction perpendicular to the surface of the ceramic substrate 13.

The melted solder material of the second solder joining section 25P, which is melted to have fluidity when the LED element 12 is mounted, is about to ooze out to the sides from the peripheral portion of the second land section 16P. However, the melted solder material is drawn into the plurality of grooves 43 by the capillary phenomenon in the plurality of grooves 43 formed in the peripheral portion of the second land section 16P and is allowed to easily flow down to the ceramic substrate 13 side from the plurality of grooves 43. The capillary phenomenon is affected by the viscosity of the solder and the size of the grooves 43. Therefore, the dimensions of the grooves 43 are desirably set taking into account the viscosity of the solder and the size of the grooves 43. To easily cause the capillary phenomenon, a metal layer excellent in wettability of the solder is desirably formed on the surfaces of the grooves 43. For example, rather than a state in which the copper plating layer is exposed in the grooves 43, the grooves 43 is preferably covered with a metal plating layer formed by one kind of metal selected out of nickel, palladium, and gold or by combining nickel, palladium, and gold.

Consequently, it is possible to reduce an amount of the melted solder material oozing out onto the second wiring section 17P from the second land section 16P. Therefore, it is possible to suppress the melted solder material from creeping up the side surfaces of the LED element 12 and prevent the LED element 12 from short-circuiting.

On the surface of the second wiring section 17P in the boundary portion between the second wiring section 17P and the second land section 16P, a plurality of grooves may be formed along the surface. In this case, likewise, the melted solder material oozing out onto the second wiring section 17P from the second land section 16P is drawn into the plurality of grooves by the capillary phenomenon in the grooves and diffused along the surface of the second wiring section 17P. Consequently, it is possible to suppress the melted solder material from creeping up the side surfaces of the LED element 12. The grooves 43 are not limited to the V shape and may be a trapezoidal shape or a U shape.

Any two or all of the width of the second wiring section 17P set smaller than the width of the second land section 16P, the step section 41 provided in the second wiring section 17P, and the grooves 43 provided in the peripheral portion of the second land section 16P may be adopted in combination.

A fourth wiring structure to the land sections 16N and 16P is shown in FIG. 8. Through-holes 45 are formed in the ceramic substrate 13 to correspond to the positions of the land sections 16N and 16P. Through-hole wiring sections 46 connected to the rear surface side of the land sections 16N and 16P are connected to the through-holes 45. The through-holes 45 and the through-hole wiring sections 46 are formed on the inside of the ceramic substrate 13 by using a multilayer substrate structure for the ceramic substrate 13.

The through-hole wiring section 46 connected to the second land section 16P on which one LED element 12 is mounted is connected to the first land section 16N on which the LED element 12 adjacent to the one LED element 12 on one side (although not shown in FIG. 8, the LED element 12 adjacent to the one LED element 12 on the right) is mounted or is connected to the power-supply wiring section 32 on the one side (see FIG. 4). The through-hole wiring section 46 connected to the first land section 16N on which the one LED element 12 is mounted is connected to the second land section 16P on which the LED element 12 adjacent to the one LED element 12 on the other side (although not shown in FIG. 8, the LED element 12 adjacent to the one LED element 12 on the left) is mounted or is connected to the power-supply wiring section 32 on the other side (see FIG. 4). Therefore, only the land sections 16N and 16P are formed on the mounting surface 13a of the ceramic substrate 13.

Since the wiring sections 17N and 17P connected to the land sections 16N and 16P are absent, the melted solder material of the second solder joining section 25P, which is melted to have fluidity when the LED element 12 is mounted, flows down from the entire peripheries of the land sections 16N and 16P to the ceramic substrate 13 side. Therefore, it is possible to suppress the melted solder material from creeping up the side surfaces of the LED element 12 and prevent the N layer 22 and the P layer 23 from short-circuiting.

The through-holes 45 may be provided to pierce through the front and rear surfaces of the ceramic substrate 13 and connected to the wiring electrode 14b formed on the rear surface 13b of the ceramic substrate 13. The wiring electrode 14b may be formed on a predetermined wiring pattern that can supply power to the plurality of LED elements 12.

In the case of the LED element 12 in which the N layer 22 and the P layer 23 are arranged opposite to the N layer 22 and the P layer 23 of the LED element 12 explained above in the embodiment, the embodiment only has to be adopted to suppress the melted solder material of the first solder joining section 25N connected to the N layer 22 from creeping up the side surfaces of the LED element 12.

The shape of the LED element viewed from the upper surface 12a is not limited to the rectangular shape and may be a square shape, a polygonal shape, or a circular shape.

The substrate is not limited to the DPC substrate 11 and may be a general printing wiring board.

The shape of the plane formed on the substrate of the land section is not limited to the square shape and may be a polygonal shape or a circular shape. The edge portion forming the contour of the plane does not have to be formed along the side surfaces of the LED element.

The solder joining section is not always included in the LED element in advance. The solder joining section may be included in the substrate in advance.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module comprising:
an LED element (12) including a first principal plane (12a) and a second principal plane (12b) on an opposite side of the first principal plane (12a), a transparent layer (21) provided on the first principal plane (12a) side, a first semiconductor layer (22) provided on the second principal plane (12b) side of the transparent layer (21), a second semiconductor layer (23) provided on the second principal plane (12b) side of the first semiconductor layer (22), and a light-emitting layer (24) provided between the first semiconductor layer (22) and the second semiconductor layer (23);
a first solder joining section (25N) provided on the second principal plane (12b) side of the first semiconductor layer (22);
a second solder joining section (25P) provided on the second principal plane (12b) side of the second semiconductor layer (23); and
a substrate (11) including a mounting surface (13a) on which the LED element (12) is mounted, a first wiring pattern (15N) including a first land section (16N), to which the first solder joining section (25N) is joined, being formed on the mounting surface (13a), a second wiring pattern (15P) including a second land section (16P), to which the second solder joining section (25P) is jointed, being formed to be opposed to the first land section (16N), and an edge portion forming an edge of at least the second land section (16P) being arranged further on an inner side of the LED element (12) than side surfaces of the LED element (12).

2. The module according to claim 1, wherein at least the second land section (16P) is arranged further on the inner side than side surfaces of the second solder joining section (25P) of the LED element (12).

3. The module according to claim 1 or 2, wherein an area of at least the second land section (16P) is smaller than an area of the second solder joining section (25P) of the LED element (12).

4. The module according to any one of claims 1 to 3, wherein the first and second wiring patterns (15N, 15P) include first and second wiring sections (17N, 17P) having width smaller than width of the first and second land sections (16N, 16P) and connected to the first and second land sections (16N, 16P).

5. The module according to claim 4, wherein, in at least the second wiring section (17P), a step section (41) lower than a surface of the second land section (16P) is provided in a boundary portion between the second wiring section (17P) and the second land section (16P).

6. The module according to any one of claims 1 to 4, wherein a plurality of groves (43) are formed on at least side surfaces of the second land section (16P).

7. The module according to any one of claims 1 to 3, wherein through-holes (45) are formed in the substrate (11) to correspond to positions of the first and second land sections (16N, 16P), and through-hole wiring sections (46) connected to the first and second land sections (16N, 16P) are formed in the through-holes (45).
